# EUROPÄISCHE PATENTSCHRIFT

(11) **EP 2 058 724 B1**
(45) Veröffentlichungstag und Bekanntmachung des Hinweises auf die Patenterteilung: **22.05.2013**
(21) Anmeldenummer: 08105345.6
(22) Anmeldetag: 15.09.2008
(51) Int. Cl.: G06F 1/20, H05K 7/20

(54) **VERFAHREN UND SYSTEM ZUR NUTZUNG DER ABWARME EINES COMPUTERSYSTEMS**
METHOD AND SYSTEM FOR USING THE WASTE HEAT OF A COMPUTER SYSTEM
PROCEDE ET SYSTEM D'UTILISATION DE LA CHALEUR PRODUITE PAR UN SYSTEME INFORMATIQUE

(30) Priorität: 06.11.2007 DE 102007053220; 21.12.2007 DE 102007062143
(43) Veröffentlichungstag der Anmeldung: 13.05.2009
(73) Patentinhaber: Fujitsu Technology Solutions Intellectual Property GmbH, 80807 München (DE)
(72) Erfinder: König, Christoph, 85521, Ottobrunn (DE)
(74) Vertreter: Epping - Hermann - Fischer

(56) Entgegenhaltungen:
- DE-A1- 10 350 358
- US-A1- 2005 132 724

## Beschreibung

Die Erfindung betrifft ein Verfahren und ein System zur Nutzung der Abwärme eines Computersystems mit einer Mehrzahl von Prozessoren.

Heutige Computersysteme, zum Beispiel die so genannten Serverfarmen, können bereits bis zu einigen tausend Prozessoren aufweisen. Angesichts einer zunehmenden Nachfrage an Netzwerkdiensten ist absehbar, dass die Anzahl der Prozessoren in zukünftigen Systemen weiter steigen wird. Mit zunehmender Leistungsfähigkeit der einzelnen Prozessoren steigt zudem auch deren Bedarf an elektrischer Leistung. Dieses resultiert zusammengenommen zum Einen in einem enormen Primärenergiebedarf (Energieverbrauch) großer Computersysteme und zum Anderen in einer großen anfallenden Wärmemenge, die durch geeignete Kühlvorrichtungen aus dem Computersystem transportiert werden muss. Häufig wird für den Abtransport der Wärme aus dem Computersystem weitere Primärenergie benötigt, zum Beispiel durch den Einsatz von Kompressorklimaanlagen zur Klimatisierung der Räume, in denen das Computersystem aufgestellt ist. Andererseits ist bekannt, die für das Computersystem eingesetzte Primärenergie zumindest teilweise wieder zu verwerten, zum Beispiel in dem die Abwärme über Wärmetauscher in ein Heizungssystem oder ein System zur Warmwasserbereitung eingekoppelt wird. Unter der Voraussetzung, dass Bedarf an Heizungswärme oder Warmwasser besteht, kann so der Gesamtenergiebedarf von Computersystem und angrenzendem Bürogebäude verringert werden.

US 2005/132724 A1 beschreibt ein Verfahren zur Reduzierung des Energieverbrauchs zur Reduzierung des Energieverbrauchs in einem Multi-Effekt-Absorptions-System. Das Multi-Effekt-Absorptions-System weist einen primären Generator für einen primären Desorptionsprozess und einen sekundären Generator für einen sekundären Desorptionsprozess auf. Bei dem Verfahren wird Wärme auf den primären Generator von einer primären Wärmequelle für die primäre Desorption bereitgestellt. Wärme erzeugende Geräte werden mit dem Multi-Effekt-Absorptionssystem gekühlt, wobei die erzeugte Wärme gesammelt und in einem sekundäre Generator zur Verwendung in einem sekundären Desorptionsprozess transferiert wird, wodurch die Menge an Wärme, die von der primären Wärmequelle benötigt wird, und der Energieverbrauch des Absorptionssystems verringert wird.

DE 103 50 358 A1 beschreibt ein Verfahren und eine Vorrichtung zur Durchführung des Verfahrens mit einem Lüfter, einem Luftkanal und einem Wärmetauscher, wobei die der Lüfter von einem Computer oder elektrischem Gerät erwärmte Abluft über den Luftkanal dem Wärmetauscher zuführt, wobei der Wärmetauscher einen Eingangsanschluss und einen Ausgangsanschluss aufweist, durch die der Wärmetauscher über ein Medium durchströmbar ist, welches sich durch die zugeführte erwärmte Abluft erwärmt.

Es ist eine Aufgabe der Erfindung, ein Verfahren und ein System zu schaffen, mit denen die Abwärme eines Computersystems mit einer Mehrzahl von Prozessoren auf vielfältige Art mit hohem Wirkungsgrad genutzt wird.

Diese Aufgabe wird durch die Merkmale der unabhängigen Patentansprüche gelöst. Weiterbildungen und vorteilhafte Ausgestaltungen sind in den jeweiligen abhängigen Patentansprüchen angegeben.

Gemäß einem ersten Aspekt der Erfindung wird die Aufgabe durch ein Verfahren zur Nutzung der Abwärme eines Computersystems mit einer Mehrzahl von Prozessoren mit den folgenden Schritten gelöst: Es werden Arbeitsaufträge im Computersystem derart mittels eines Schedulers an die Prozessoren verteilt, dass Prozessoren einer ersten Gruppe von Prozessoren mit hoher Auslastung betrieben werden und Prozessoren einer zweiten Gruppe von Prozessoren mit nur geringer Auslastung betrieben werden. Die Abwärme der Prozessoren wird an eine Vorrichtung zur Nutzung der Abwärme übertragen.

Bei der Erfindung wird ausgenutzt, dass sich Abwärme umso effizienter nutzen lässt, je höher das Temperaturniveau ist, auf dem diese Abwärme zur Verfügung steht. Beispielsweise ergibt sich bei einer Nutzung der Abwärme durch einen thermodynamischen Kreisprozesses gemäß Carnot ein maximaler Wirkungsgrad von η = 1 - Th / Tk. Dabei gibt Th das Temperaturniveau an, mit dem die Abwärme zur Verfügung steht und Tk das Temperaturniveau, auf das ein Arbeitsmittel in dem thermodynamischen Kreisprozess durch ein Kühlvorrichtung heruntergekühlt wird. Eine wirtschaftliche Kühlmethode ist dabei üblicherweise an die Temperatur der Umgebungsluft oder die Temperatur eines Kaltwasserzuflusses gebunden, so dass für den Wert von Tk nur eine geringe Variationsmöglichkeit gegeben ist. Erfindungsgemäß wird ein hoher Wirkungsgrad η dadurch erzielt, dass die Temperatur Th, mit der die Abwärme vom Computersystem abgeführt wird, soweit wie möglich erhöht wird.

Gemäß dem ersten Aspekt der Erfindung wird ein hohes Temperaturniveau für die Abwärme dadurch erreicht, dass Arbeitsaufträge in Computersystemen so auf verschiedene Prozessoren verteilt werden, dass mindestens zwei Gruppen von Prozessoren gebildet werden, wobei die Prozessoren der ersten Gruppe mit hoher Auslastung betrieben werden.

Die aufgenommene elektrische Leistung eines Prozessors hängt von der Spannung und der Taktfrequenz, mit der der Prozessor betrieben wird, ab. Weiterhin nimmt die aufgenommene elektrische Leistung mit der Auslastung des Prozessors zu, da die von einem nicht voll ausgelasteten Prozessor ausgeführten Null-Operationen zu einer geringeren Stromaufnahme des Prozessors führen, als andere Operationen. Die Temperatur, die sich an einem Prozessor einstellt, resultiert aus der aufgenommenen elektrischen Leistung sowie der pro Zeiteinheit abgeführten Wärmemenge (Kühlleistung). Bei gegebener Wärmeabfuhr steigt folglich mit wachsender Auslastung der Prozessoren der ersten Gruppe deren Temperatur.

Die zweite Gruppe von Prozessoren wird dagegen mit einer möglichst geringen Auslastung betrieben, so dass sie möglichst wenig Energie benötigen. Zusätzlich ist es in einer bevorzugten Ausgestaltung der Erfindung möglich, die Taktfrequenz und die Spannung, mit der diese Prozessoren betrieben werden, gegenüber dem Normalbetrieb herunterzusetzen, um ihre Leistungsaufnahme weiter zu senken. Im Gegensatz zur üblichen Art und Weise, Arbeitsaufträge innerhalb eines Computersystems möglichst gleichmäßig auf die Prozessoren zu verteilen, wird erfindungsgemäß folglich eine möglichst inhomogene Verteilung der Arbeitsaufträge auf die Prozessoren der ersten und der zweiten Gruppe von Prozessoren angestrebt.

Gemäß einer Ausgestaltung der Erfindung wird die Aufgabe durch ein Verfahren zur Nutzung der Abwärme eines Computersystems mit einer Mehrzahl von Prozessoren mit den folgenden Schritten gelöst: Die Abwärme von den Prozessoren wird durch eine Kühlvorrichtung abgeführt, wobei die von den Prozessoren jeweils abgeführte Wärmemenge derart von der Kühlvorrichtung geregelt wird, dass der Prozessor an Temperatur annimmt, die größer ist als eine vorgegebene Mindesttemperatur. Die Abwärme der Prozessoren wird wiederum an eine Vorrichtung zur Nutzung der Abwärme übertragen.

Gemäß der Ausgestaltung der Erfindung wird ein hohes Temperaturniveau für die Abwärme der einzelnen Prozessoren erreicht, indem die Abfuhr der Abwärme von den Prozessoren durch die Kühlvorrichtung so beschränkt wird, dass sich bei gegebener Auslastung und der dabei aufgenommenen elektrischen Leistung mindestens eine vorgegebene Mindesttemperatur einstellt. Wird die Mindesttemperatur ausreichend hoch gewählt, kann eine effiziente Nutzung der Abwärme erfolgen. Bevorzugt kann die Mindesttemperatur, angegeben in °C, beispielsweise mehr als 80% der für die Prozessoren zulässigen Maximaltemperatur, angegeben in °C, betragen. Damit kann ein Temperaturniveau der Abwärme von 70° bis 100° C erreicht werden, ohne dass es zu Fehlfunktionen der Prozessoren oder zu einer Verkürzung ihrer Lebensdauer kommt.

Gemäß einem zweiten Aspekt der Erfindung wird die Aufgabe durch ein System gelöst, das ein Computersystem mit einer Mehrzahl von Prozessoren, eine Kühlvorrichtung zum Abführen der Abwärme mindestens eines Teils der Prozessoren und eine Vorrichtung zur Nutzbarmachung der Abwärme der Prozessoren aufweist. Das System ist dabei zur Durchführung einer der zuvor genannten Verfahren eingerichtet. Die Vorteile des dritten Aspekt entsprechen denen des ersten und zweiten Aspekts. Die Erfindung wird im Folgenden anhand von Ausführungsbeispielen mit Hilfe von dem Figuren 1 und 2 näher erläutert. Bei Figur 3 handelt es sich nicht um eine Ausführungsform der Erfindung, sondern um ein Beispiel, das das Verständnis der Erfindung erleicht.

Es zeigen:

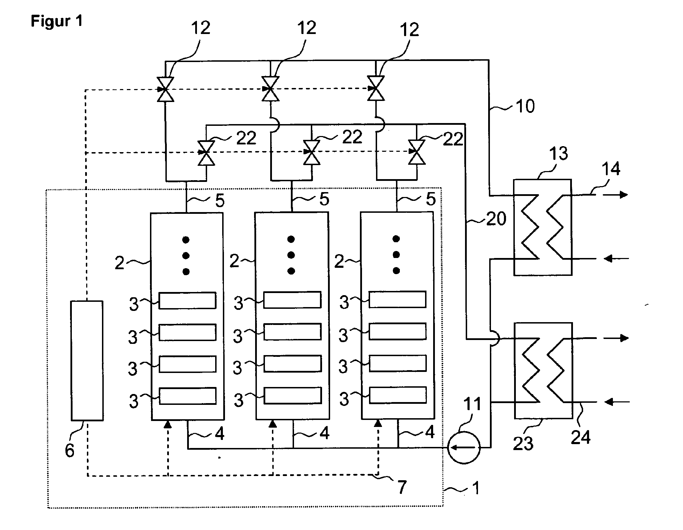

Figur 1 ein Computersystem mit einer Mehrzahl von Prozessoren und einer Kühlvorrichtung zur Nutzbarmachung der Abwärme der Prozessoren.

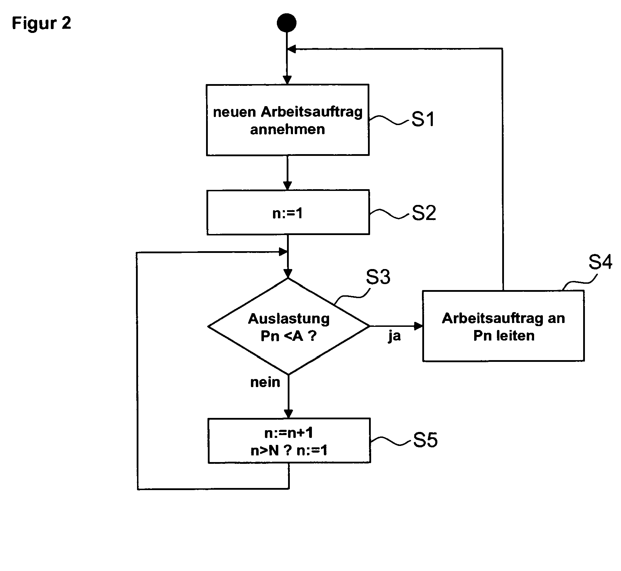

Figur 2 ein Flussdiagramm eines Verfahrens zum Verteilen von Aufgaben an Prozessoren eines Computersystems und

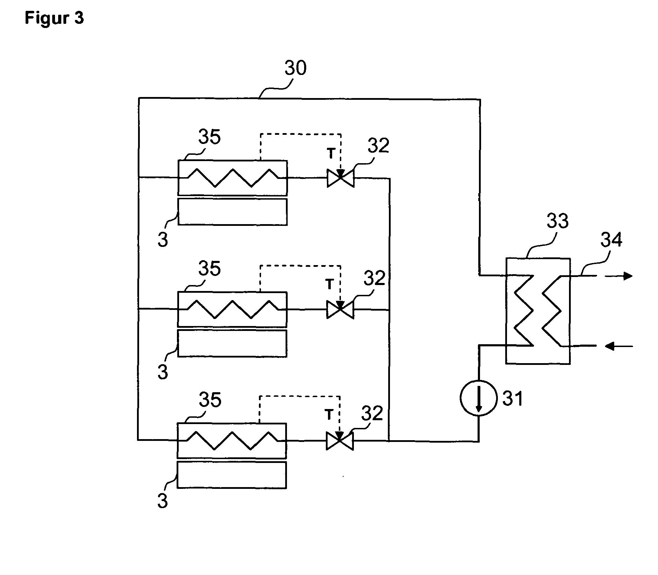

Figur 3 einer Kühlvorrichtung zur Nutzbarmachung der Abwärme von Prozessoren eines Computersystems.

Figur 1 zeigt schematisch ein Computersystem 1, das in mehreren Serverschränken 2 eine Mehrzahl von Servern mit jeweils einem oder mehreren Prozessoren 3 aufweist. Weiterhin ist im Computersystem ein Scheduler 6 zur Verteilung von Aufgaben an die Prozessoren 3 des Computersystems 1 vorgesehen. Der Scheduler 4 ist über ein Verwaltungsnetzwerk 7 mit den Prozessoren des Computersystems 1 verbunden. Jeder Serverschrank 2 ist über einen Kühlmittelzulauf 4 und einem Kühlmittelablauf 5 an einen Kühlmittelkreislauf 10 mit Kühlmittelpumpe 11, Ventilen 12 und einem Wärmetauscher 13 angebunden. Der Wärmetauscher 13 koppelt den Kühlmittelkreislauf 10 thermisch an einen Nutzkreislauf 14. Darüber hinaus ist ein weiterer Kühlmittelkreislauf 20 vorgesehen, der ebenfalls mit den Serverschränken 2 verbunden ist. Der weitere Kühlmittelkreislauf 20 weist eine weitere Kühlmittelpumpe 21, weitere Ventile 22 und einen weiteren Wärmetauscher 23 auf, über den der weitere Kühlmittelkreislauf 20 thermisch an einen weiteren Nutzkreislauf 24 gekoppelt ist. Zur Steuerung sind die Ventile 12 und die weiteren Ventile 22 mit dem Scheduler 6 verbunden.

Das in Figur 1 gezeigte Computersystem 1 stellt beispielhaft eine so genannte Serverfarm oder einen Teil einer Serverfarm dar. Anstelle der Serverschränke 2, auch Serverracks genannt, kann das Computersystems 1 bezüglich der Verbindung an die Kühlmittelkreisläufe 10, 20 auch in andere Untereinheiten unterteilt sein, zum Beispiel in einzelne Computer, Server oder die Prozessoren 3. Das im Folgenden beschriebene Verfahren kann mit einer solchen Unterteilung analog auch auf andere Computersysteme mit einer Mehrzahl von Prozessoren als Serverfarmen übertragen werden.

Zur Kühlung der Prozessoren 3 ist eine Kühlvorrichtung mit einer Flüssigkeitskühlung vorgesehen. Jeder Serverschrank 2 weist zu diesem Zweck den Kühlmittelzulauf 4 und den Kühlmittelablauf 5 auf, über die das Kühlmittel, beispielsweise Wasser, der Flüssigkeitskühlung den Prozessoren 3 zugeführt beziehungsweise von diesen abgeführt wird.

Innerhalb der Serverschränke 2 sind nicht dargestellt Wärmetauscher vorgesehen, die die Abwärme der Prozessoren 3 aufnehmen und auf das Kühlmittel übertragen. Zur besseren Unterscheidbarkeit von den Wärmetauschern 13 und 23 werden die Wärmetauscher, die die Abwärme der Prozessoren 3 aufnehmen, im Folgenden als Wärmeaufnehmer bezeichnet. Diese Wärmeaufnehmer können dabei entweder direkt thermisch mit den Prozessoren 3 gekoppelt sein oder auch über ein wärmeleitendes Element, beispielsweise ein Wärmerohr (Heat-Pipe). Es ist denkbar, für jeden Prozessor 3 einen Wärmeaufnehmer vorzusehen oder auch jeweils eine Gruppe von Prozessoren 3, beispielsweise alle Prozessoren 3 eines Servers, thermisch mit einem Wärmeaufnehmer zu verbinden. Bevorzugt sind alle Wärmeaufnehmer eines Serverschranks 2 bezüglich des Kühlmitteldurchflusses parallel angeordnet. In Einzelfällen, zum Beispiel wenn zu einem Prozessor 3 aus Redundanzgründen ein Ersatzprozessor vorgesehen ist und der Prozessor 3 und sein Ersatzprozessor üblicherweise nicht gleichzeitig betrieben werden, ist auch eine Serienverschaltung der Wärmeaufnehmer dieser Prozessoren 3 denkbar.

Über die Ventile 12 beziehungsweise die weiteren Ventile 22 kann der Kühlmittelablauf 5 eines jeden Serverschranks 2 entweder mit dem Kühlmittelkreislauf 10 oder dem weiteren Kühlmittelkreislauf 20 verbunden werden. Die von den Prozessoren 3 eines jeden Serverschranks 2 erzeugte und vom Kühlmittel aufgenommene Abwärme kann somit entweder dem Wärmetauscher 13 oder dem weiteren Wärmetauscher 23 zugeführt werden. Im Ausführungsbeispiel erfolgt der Rücklauf des Kühlmittels von dem Wärmetauscher 13 und dem weiteren Wärmetauscher 23 gemeinsam über die Kühlmittelpumpe 11 zu den Zuläufen 4 der Serverschränke 2. Es ist alternativ ebenfalls möglich, für jeden Kühlmittelkreislauf 10, 20 eine Kühlmittelpumpe vorzusehen und analog zu den Ventilen 12 und den weiteren Ventilen 22 im Ablaufzweig des Kühlmittels von den Serverschränken 2 solche Ventile auch im Zulaufzweig vorzusehen.

In den Wärmetauschern 13 beziehungsweise 23 wird die Abwärme der Prozessoren 3 zur Nutzbarmachung in die Nutzkreisläufe 14 beziehungsweise 24 übertragen. Die Nutzkreisläufe 14, 24 können dabei zum Beispiel Wasserkreisläufe eines Heizsystems oder einer Warmwasseraufbereitung sein. Ebenfalls ist denkbar, dass die Nutzkreisläufe 14, 24 Arbeitsmittelkreisläufe eines thermodynamischen Kreisprozesses sind. Beispielsweise kann eine Absorptionskältemaschine durch diesen Kreisprozess angetrieben werden, wobei die auf diese Weise aus der Abwärme der Prozessoren 3 erzeugte Kühlleistung zur Klimatisierung der Räume, in denen das Computersystem 1 untergebracht ist, eingesetzt werden. Auch ist denkbar, in dem thermodynamischen Kreisprozess die Abwärme der Prozessoren 3 zur Dampferzeugung und nachfolgenden Umsetzung der Wärmeenergie in mechanische Energie in einer Dampfturbine einzusetzen. Die von einem mit der Dampfturbine gekoppelten Generator erzeugte elektrische Energie kann zur teilweisen Deckung des Primärenergiebedarfs des Computersystems 1 eingesetzt werden. Zur Umsetzung der Abwärme der Prozessoren 3 in mechanische Energie eignet sich insbesondere der so genannte Kalina-Prozess, bei dem durch Einsatz eines Ammoniak-Wasser-Gemisches als Arbeitsmittel des Kreisprozesses eine Dampferzeugung bereits auf relativ niedrigem Temperaturniveau möglich ist.

Aufgabe des Schedulers 6 ist es, im Computersystem 1 auszuführende Arbeitsaufgaben, auch Tasks, Jobs oder Prozesse genannt, an die einzelnen Prozessoren 3 zu verteilen. Der Scheduler 6 kann dabei auf einem eigens für Verwaltungszwecke vorgesehenen Computer innerhalb des Computersystems 1 ausgeführt werden. Es ist aber auch denkbar, dass die Aufgaben des Schedulers 6 von einem der Prozessoren 3 der Server des Computersystems 1 zentral oder von mehreren der Prozessoren 3 dezentral übernommen wird.

Der Scheduler 6 ist dazu eingerichtet, anfallende Arbeitsaufträge so an die Prozessoren 3 zu verteilen, dass ein Teil der Prozessoren 3 mit einer möglichst hohen Auslastung betrieben wird, während ein anderer Teil der Prozessoren 3 mit einer möglichst geringen Auslastung betrieben wird.

Figur 2 zeigt in einem Flussdiagramm ein stark vereinfachtes Ausführungsbeispiel eines Arbeitsverfahrens für den Scheduler 6, mit dem eine solche möglichst große Ungleichverteilung in der Arbeitsbelastung der Prozessoren 3 des Computersystems 1 erreicht wird.

In einem ersten Schritt S1 nimmt der Scheduler 6 einen neuen Arbeitsauftrag entgegen. Beispielhaft verfüge das Computersystem 1 über eine Anzahl N von Prozessoren 3. Die einzelnen Prozessoren 3 sind aufsteigend so durchnummeriert, dass den Prozessoren 3 der einzelnen Serverschränke 2 zusammenhängende Nummernblöcke zugeordnet sind. In einem Schritt S2 wird eine Variable n zum Indizieren der einzelnen Prozessoren 3 auf den Anfangswert 1 gesetzt. Im nachfolgenden Schritt S3 wird die Auslastung des Prozessors 3, dem die Nummer n zugeordnet ist überprüft. In Figur 3 ist dieser Prozessor 3 als Pn bezeichnet. Falls die Auslastung des Prozessors mit der Nummer n kleiner ist als eine vorgegebene Auslastung A, wird der Auftrag diesem Prozessor 3 mit der Nummer n zur Ausführung übertragen. Das Verfahren verzweigt danach wieder zu Schritt S1 zur Entgegennahme neuer Arbeitsaufträge. Wurde in Schritt S3 dagegen festgestellt, dass die Auslastung des Prozessors mit der Nummer n bereits oberhalb der vorgegebenen Auslastung liegt, wird im Schritt S5 die Indizierungsvariable n um 1 erhöht und auf den Wert 1 gesetzt, falls n nach dem Inkrementieren größer als N sein sollte. Danach wird Schritt S3 mit dem neuen Wert der Indizierungsvariable n wiederholt.

Durch das Verfahren werden die Prozessoren 3 in zwei Gruppen von Prozessoren unterteilt, von denen die Prozessoren 3 der ersten Gruppe mit einer Auslastung größer A betrieben werden, wohingegen die Prozessoren der zweiten Gruppe nur gering oder gar nicht ausgelastet werden. Wenn n* den Wert angibt, bei dem in Schritt S4 der letzte Arbeitsauftrag an den Prozessor mit der Nummer n* übertragen wurde, werden folglich die Prozessoren mit den Nummern 1 bis n*-1 mit einer Auslastung größer A betrieben und bilden die erste Gruppe, wohingegen die die Prozessoren mit den Nummern n* bis N mit einer nur geringen Auslastung betrieben werden und die zweite Gruppe bilden. Die Grenze n* verschiebt sich dabei dynamisch mit dem anfallenden Arbeitsvolumen.

In alternativen Ausgestaltungen des Verfahrens kann vorgesehen sein, die Nummerierung der Prozessoren 3 beziehungsweise die Reihenfolge, in der die Auslastung der Prozessoren abgefragt wird, von Zeit zu Zeit so zu ändern, dass nicht immer die gleichen Prozessoren 3 zuerst der ersten Gruppe zugeordnet werden. Auf diese Weise wird erreicht, dass die Prozessoren 3 gemittelt über ihre Lebensdauer gleichmäßig ausgelastet werden. Weiterhin ist es denkbar, dass die tatsächliche Temperatur eines Prozessors in das Verteilungsverfahren mit einfließt.

Zur Einsparung von Primärenergie können die Prozessoren 3 der zweiten Gruppe mit gegenüber dem Normalbetrieb verminderter Spannung und verminderter Taktfrequenz betrieben werden. Bestimmte Prozesse, die in dem Computersystem 1 ausgeführt werden, werden grundsätzlich auf jedem Prozessor 3 ablaufen müssen, zum Beispiel Prozesse zur internen Verwaltung der Server, zur Aufrechterhaltung der Arbeitsbereitschaft der Server oder zum Bereitstellen eines Betriebssystems auf jedem Server. Diese Prozesse führen zu einer Grundlast auch der Prozessoren 3 der zweiten Gruppe.

Vorteilhaft kann diese Grundlast verringert werden, indem das Computersystem 1 ganz oder teilweise mit Computern betrieben wird, die virtuelle Maschinen bereitstellen. Auf Computern mit virtuellen Maschinen, oft auch als virtuelle Maschinensysteme bezeichnet, können verschiedene Anwender Aufgaben unabhängig und getrennt voneinander bearbeiten. In virtuelle Maschinensystemen werden die gemeinsam genutzten Hardwareressourcen eines Computers oder Computersystems auf mehrere virtuelle Umgebungen, die so genannten virtuelle Maschinen, aufgeteilt. Für den oder die Anwender stellen sich die virtuellen Maschinen als eigenständige, unabhängige Einheiten dar. Unabhängig bedeutet in diesem Zusammenhang, dass auf den einzelnen virtuellen Maschinen unterschiedliche Betriebssysteme mit verschiedensten Applikationen, Programmen oder Skripten ausgeführt werden können. Die virtuellen Maschinen sind dabei gegeneinander abgeschottet, so dass ein Zugriff von einer virtuellen Maschine auf die von einer anderen virtuellen Maschine genutzten Ressourcen (zum Beispiel Speicherbereich) nicht möglich ist.

Falls ein Anwender nicht die gesamte Rechenleistung eines Computers, zum Beispiel eines Servers, beansprucht, können die Anwendungen des Anwenders auf einer virtuellen Maschine ausgeführt werden. Mehrere solcher Anwender können sich dann einen mehrere virtuelle Maschinen aufweisenden Server teilen, ohne dass dies für die Anwender zu Qualitäts- oder Sicherheitsbeeinträchtigungen für ihre Anwendungen führt. Bei Unterauslastung einer Serverfarm (oder allgemein eines Computersystems mit mehreren Prozessoren 3) können so für die verschiedenen Anwender abgeschottete Arbeitsumgebungen (zum Beispiel Betriebssysteme) bereitgestellt werden, die jedoch auf weniger Servern (oder allgemeiner Computern beziehungsweise Prozessoren 3) ausgeführt werden können, als abgeschottete Arbeitsumgebungen vorhanden sind. Die vom Computersystem zu erbringende Arbeitsleistung kann auf wenige Prozessoren (die Prozessoren 3 der ersten Gruppe) konzentriert werden. Die nicht benötigten Prozessoren (die Prozessoren 3 der zweiten Gruppe) können dann ganz abgeschaltet werden oder in einen nur wenig Strom verbrauchenden Zustand versetzt werden. Die zur Bereitstellung der Betriebssysteme insgesamt notwendige Leistungsaufnahme des Computersystems kann so verringert werden.

Auch ist es möglich, ein virtuelles Maschinensystem einzurichten, das sich der Rechenleistung einer variablen Zahl von Computersystemen bedient und diese wiederum einer ebenso variablen Zahl von Anwendern in jeweils abgeschotteten Arbeitsumgebungen bereitstellt. In einem solchen Fall kann jedem Anwender im Rahmen der insgesamt verfügbaren Arbeitsleistung des Computersystems jederzeit eine beliebige Arbeitsleistung bereitgestellt werden. Gleichzeitig können wiederum alle nicht in Anspruch genommenen Prozessoren (die Prozessoren 3 der zweiten Gruppe) abgeschaltet werden.

Im Ausführungsbeispiel der Figur 1 steuert der Scheduler 6 als eine weitere Aufgabe die Ventile 12 und die weiteren Ventile 22. Jeweils eines der Ventile 12 und der weiteren Ventile 22, die einem Serverschrank 2 zugeordnet sind, ist dabei geöffnet während das andere geschlossen ist. Abhängig von der Auslastung des Computersystems 1 werden nun solche Serverschränke 2, bei denen alle Prozessoren 3 zur ersten Gruppe der Prozessoren mit hoher Auslastung gehören, an den Kühlmittelkreislauf 10 angebunden und alle anderen Serverschränke 2 an den weiteren Kühlmittelkreislauf 20.

Entsprechend der Trennung der Prozessoren 3 in die erste Gruppe von hoch ausgelasteten Prozessoren 3 und die zweite Gruppe von nur gering ausgelasteten Prozessoren 3 wird sich für die Serverschränke 2, bei denen alle Prozessoren 3 mit hoher Auslastung betrieben werden, eine hohe Temperatur des Kühlmittels im Kühlmittelablauf 5 einstellen. Dementsprechend steht im Nutzkreislauf 14 Abwärme auf einem hohen Temperaturniveau zur Verführung, wohingegen im Nutzkreislauf 24 Abwärme auf einem niedrigeren Temperaturniveau bereitsteht.

Die Abwärme auf niedrigerem Temperaturniveau im Nutzkreislauf 24 kann für solche Anwendungen eingesetzt werden, bei denen eine niedrige Temperatur ausreichend ist, beispielsweise zu Heizzwecken oder zur Warmwasserbereitung. In einer alternativen Ausgestaltung kann auch vorgesehen sein, dass die auf niedrigem Temperaturniveau anfallende Abwärme verworfen wird, zum Beispiel indem sie an die Umluft abgegeben wird.

Dagegen kann die auf hohem Temperaturniveau bereitstehende Abwärme vorteilhaft und effizient im Nutzkreislauf 14 für solche Prozesse genutzt werden, die eines entsprechend hohen Temperaturniveaus bedürfen oder deren Wirkungsgrad mit steigender Temperatur ansteigt. Dieses sind insbesondere thermodynamische Kreisprozesse zum Betrieb einer Wärmekraftmaschine zur Stromerzeugung oder zum Betrieb einer Absorptionskältemaschine. Durch die Verteilung der Arbeitsaufträge innerhalb des Computersystems 1 kann auf hohem Temperaturniveau entstehende Abwärme vorteilhaft getrennt von Abwärme auf einem niedrigeren Temperaturniveau verarbeitet werden. Da der Wirkungsgrad der Umwandlung von Abwärme in andere, besser nutzbare Energieformen von dem Temperaturniveau der Abwärme abhängt, ist auf diese Weise eine effiziente Nutzung der Abwärme möglich.

Als Alternative zur Steuerung der Ventile 12 und der weiteren Ventile 22 durch den Scheduler 6 kann eine Steuerung auch abhängig von der Temperatur des Kühlmittels am Kühlmittelablauf 7 eines jeden Serverschranks 2 (beziehungsweise allgemeiner am Kühlmittelablauf einer jeden Untereinheit des Computersystems) erfolgen.

Figur 3 zeigt eine Kühlvorrichtung für Prozessoren 3 eines Computersystems 1, das ebenfalls geeignet ist, die Abwärme der Prozessoren 3 auf einem hohen Temperaturniveau bereitzustellen.

Jeder Prozessor 3 steht in direktem Wärmekontakt mit einem Wärmetauscher 35, dem jeweils ein Regelventil 32 vorgeschaltet. Die Wärmeaufnehmer 35 und zugeordnete Regelventile 32 sind parallel in einem Kühlmittelkreislauf 30 angeordnet, der zudem eine Kühlmittelpumpe 31 und einen Wärmetauscher 33 aufweist. Über den Wärmetauscher 33 ist der Kühlmittelkreislauf 30 thermisch mit einem Nutzkreislauf 34 gekoppelt.

Die sich an einem der Prozessoren 3 einstellende Temperatur ergibt sich aus dem Gleichgewicht zwischen umgesetzter elektrischer Leistung im Prozessor 3 und der durch den Wärmeaufnehmer 35 von dem Prozessor 3 aufgenommenen und durch den Kühlmittelkreislauf 30 abgeführten Wärmemenge. Die Regelventile regulieren den Durchfluss des Kühlmittels durch den entsprechenden zugeordneten Wärmeaufnehmer 35 und beeinflussen damit die von dem Prozessor 3 abgeführte Wärmemenge. Die Regelventile 32 werden dabei durch einen Regelkreis abhängig von der Temperatur des Wärmeaufnehmers 35 geregelt. Dabei ist der Regelkreis beispielsweise so eingerichtet, dass unterhalb einer vorgegebenen Mindesttemperatur kein oder nur ein sehr geringer Kühlmitteldurchfluss erfolgt und dass bei einer vorgegebenen Maximaltemperatur der maximal mögliche Kühlmitteldurchfluss erreicht wird. Auf diese Weise stellt sich unabhängig von der im Prozessor 3 in Abwärme umgesetzten elektrischen Leistung eine Temperatur am Wärmeaufnehmer 35 ein, die zwischen der vorgegebenen Mindest- und der vorgegebenen Maximaltemperatur liegt. Die vorgegebene Maximaltemperatur ist dabei sinnvollerweise so zu wählen, dass Herstellervorgaben für die Maximaltemperatur des Prozessors, bei der der Prozessor weder Beschädigung erfährt, noch eine erhöhte Fehlerwarte zeigt, nicht übersteigt. Die vorgegebene Mindesttemperatur kann dagegen so hoch gewählt werden, dass Abwärme auf einem wirtschaftlich effizient ausnutzbaren Temperaturniveau am Wärmetauscher 33 und damit im Nutzkreislauf 34 bereitsteht. Beispielsweise kann die Mindesttemperatur 80 % der am Prozessor maximal erlaubten Temperatur betragen, wobei sich die Prozentangabe auf eine Temperaturangabe in °C (Grad Celsius) bezieht.

Der Wärmeaufnehmer 35 entspricht in seinen Abmessungen und der Position von Befestigungselementen bevorzugt der Vorgabe des Prozessorherstellers für Kühlkörper für diesen Prozessor. Das Regelventil 32 kann dabei in den Wärmeaufnehmer integriert sein und mechanisch, zum Beispiel durch ein Bimetallelement, temperaturabhängig betätigt werden. Auf diese Weise entsteht ein kompaktes Flüssigkeitskühlelement für einen Prozessor.

Alternativ zu dem in dem Ausführungsbeispiel der Figur 3 gezeigten Regelkreis, bei dem die Temperatur des Wärmeaufnehmers 35 als Ist-Wert der Regelung einsetzt wird, kann eine Temperaturregelung auch auf Basis der Temperatur des Prozessors 3 erfolgen. Die Temperatur von Prozessoren wird üblicherweise vom Prozessor selbst in digitaler Form bereitgestellt und kann so auf einfache Weise zur Steuerung eines elektrisch betätigen Regelventils 32 eingesetzt werden.

Weiterhin ist es möglich, zur Kühlung der Prozessoren einen thermodynamischen Kreisprozess vorzusehen, bei dem in den Wärmeaufnehmer 35 direkt ein Arbeitsmittel verdampft wird oder bei dem ein Verdampfer thermisch mit dem Wärmetauscher 33 gekoppelt ist. Aufgrund der hohen latenten Verdampfungswärme von Flüssigkeiten nimmt der Wärmeaufnehmer 35 oberhalb der Verdampfungstemperatur eine mit der Temperatur sprunghaft ansteigende Wärmemenge auf. Durch den hochgradig nichtlinearen Verlauf der aufgenommenen Wärmemenge in Abhängigkeit der Temperatur entsteht eine sich selbst auf die Verdampfungstemperatur regelnde Kühlvorrichtung.

Merkmale der gezeigten Ausführungsbeispiele können auch miteinander kombiniert eingesetzt werden, beispielsweise indem das in Figur 2 dargestellte Verfahren zum Verteilen der Arbeitsaufträge mit einer Kühlvorrichtung wie in Figur 3 angegeben kombiniert wird.

### Bezugszeichenliste

- 1: Computersystem
- 2: Serverschrank
- 3: Prozessor
- 4: Kühlmittelzulauf
- 5: Kuhlmittelablauf
- 6: Scheduler
- 7: Verwaltungsnetzwerk
- 10, 20, 30: Kühlmittelkreislauf
- 11, 31: Kühlmittelpumpe
- 12, 22: Ventil
- 13, 23, 33: Wärmetauscher
- 14, 24, 34: Nutzkreislauf
- 32: Regelventil
- 35: Wärmeaufnehmer

## Patentansprüche

1. Verfahren zur Nutzung der Abwärme eines Computersystems (1) mit einer Mehrzahl von Prozessoren (3), mit den folgenden Schritten:
- Verteilen von Arbeitsaufträgen im Computersystem (1) an die Prozessoren (3) mittels eines Schedulers (6) derart, dass Prozessoren (3) einer ersten Gruppe von Prozessoren (3) mit möglichst hoher Auslastung betrieben werden und Prozessoren (3) einer zweiten Gruppe von Prozessoren (3) mit möglishst geringer Auslastung betrieben werden und
- Übertragen der Abwärme der Prozessoren (3) der ersten und zwerten Gruppen an zwei verschiedene Kühlmittelkreisläufe (10, 20) mittels vom Scheduler (6) gesteuerter Ventile (12, 22) zur Nutzung der Abwärme.

2. Verfahren nach Anspruch 1, bei dem nur Abwärme von Prozessoren (3) der ersten Gruppe an die Vorrichtung zur Nutzung der Abwärme übertragen wird.

3. Verfahren nach Anspruch 2, bei dem eine weitere Vorrichtung zur Nutzung der Abwärme vorgesehen ist, wobei die Abwärme der Prozessoren (3) des Computersystems (1), die ihre Abwärme nicht an die Vorrichtung zur Nutzung der Abwärme übertragen, an die weitere Vorrichtung zur Nutzung der Abwärme übertragen wird.

4. Verfahren nach einem der Ansprüche 1 bis 3, bei dem die Prozessoren (3) der zweiten Gruppe von Prozessoren (3) in einem Modus mit geringerer Spannung und/oder geringerer Taktfrequenz als im Modus des normalen Betriebs betrieben werden.

5. Verfahren nach einem der Ansprüche 1 bis 4, bei welchem die Abwärme von den Prozessoren (3) durch eine Kühlvorrichtung abgeführt wird, wobei die von den Prozessoren (3) jeweils abgeführte Wärmemenge derart von der Kühlvorrichtung geregelt wird, dass der Prozessor (3) eine Temperatur annimmt, die größer ist als eine vorgegebene Mindesttemperatur.

6. Verfahren nach einem der Ansprüche 1 bis 5, bei dem die von den Prozessoren (3) des Computersystems (1) erzeugte Abwärme zumindest teilweise in ein Heizungssystem und/oder ein System zur Bereitstellung von Warmwasser übertragen wird.

7. Verfahren nach einem der Ansprüche 1 bis 6, bei dem die von den Prozessoren (3) des Computersystems (1) erzeugte Abwärme zumindest teilweise einem thermodynamischen Kreisprozess zugeführt wird.

8. Verfahren nach Anspruch 7, bei dem die von den Prozessoren (3) des Computersystems (1) erzeugte Abwärme ein Wärmekraftmaschine antreibt.

9. Verfahren nach Anspruch 8, bei dem in dem thermodynamischen Kreisprozess durch die von den Prozessoren (3) des Computersystems (1) erzeugte Abwärme ein Arbeitsmittel verdampft wird und das Arbeitsmittel in einer Dampfturbine unter Abgabe von mechanischer Leistung entspannt wird.

10. Verfahren nach einem der Ansprüche 7 bis 9, bei dem der thermodynamische Kreisprozess ein Kalina-Prozess ist.

11. Verfahren nach Anspruch 7, bei dem die von den Prozessoren (3) des Computersystems (1) erzeugte Abwärme eine Absorptionskältemaschine antreibt.

12. Verfahren nach einem der Ansprüche 7 bis 11, bei dem eine Vielzahl von Verdampfern zum Verdampfen des Arbeitsmittels vorgesehen ist, die jeweils in unmittelbarem thermischen Kontakt mit wenigstens einem Prozessor (3) stehen.

13. Verfahren nach einem der Ansprüche 7 bis 11, bei dem eine Vielzahl von Wärmeaufnehmern (35) vorgesehen ist, die jeweils in unmittelbarem thermischen Kontakt mit wenigstens einem Prozessor (3) stehen, und ein mit den Wärmeaufnehmern über ein zirkulierendes Kühlmittel thermisch gekoppelter Wärmetauscher (13, 23, 33) vorgesehen ist, der in unmittelbaren thermischen Kontakt mit einem Verdampfer zum Verdampfen des Arbeitsmittels steht und bei die von den Prozessoren (3) abgegebene Abwärme über die Wärmeaufnehmer (35), das Kühlmittel und den Wärmetauscher (13, 23, 33) auf den Verdampfer übertragen wird.

14. Verfahren nach einem der Ansprüche 1 bis 13, bei dem auf zumindest einem Teil der Prozessoren (3) des Computersystems (1) ein virtuelles Maschinensystem ausgeführt wird.

15. System umfassend
- ein Computersystem (1) mit einer Mehrzahl von Prozessoren (3),
- ein Kühlvorrichtung zum Abführen der Abwärme mindestens eines Teils der Prozessoren (3) und
- einer Vorrichtung zur Nutzbarmachung der Abwärme der Prozessoren (3),
**dadurch gekennzeichnet, dass** das System zur Durchführung eines Verfahrens nach einem der Ansprüche 1-14 geeignet ist.

## Claims

1. Method of using the waste heat from a computer system (1) having a plurality of processors (3), comprising the following steps:
- distributing tasks in the computer system (1) to the processors (3) by means of a scheduler (6) in such a way that processors (3) of a first group of processors (3) are operated with the highest possible utilization level and processors (3) of a second group of processors (3) are operated with the lowest possible utilization, and
- transferring the waste heat from the processors (3) of the first and second groups to two different coolant circuits (10, 20) by means of valves (12, 22) which are controlled by the scheduler (6) for the purpose of using the waste heat.

2. Method according to Claim 1, in which only waste heat from processors (3) of the first group is transferred to the apparatus for using waste heat.

3. Method according to Claim 2, in which a further apparatus for using waste heat is provided, wherein the waste heat from the processors (3) of the computer system (1) which do not transfer their waste heat to the apparatus for using waste heat is transferred to the further apparatus for using waste heat.

4. Method according to one of Claims 1 to 3, in which the processors (3) of the second group of processors (3) are operated in a mode with a lower voltage and/or lower clock frequency than in the mode of normal operation.

5. Method according to one of Claims 1 to 4, in which the waste heat from the processors (3) is dissipated by a cooling apparatus, wherein the quantity of heat which is dissipated by the processors (3) in each case is controlled by the cooling apparatus in such a way that the processor (3) assumes a temperature which is greater than a predefined minimum temperature.

6. Method according to one of Claims 1 to 5, in which the waste heat which is generated by the processors (3) of the computer system (1) is transferred at least partially to a heating system and/or a system for providing hot water.

7. Method according to one of Claims 1 to 6, in which the waste heat which is generated by the processors (3) of the computer system (1) is supplied at least partially to a thermodynamic cycle.

8. Method according to Claim 7, in which the waste heat which is generated by the processors (3) of the computer system (1) drives a thermal power machine.

9. Method according to Claim 8, in which a working medium is evaporated in the thermodynamic cycle by the waste heat which is generated in the processors (3) of the computer system (1), and the working medium is expanded in a steam turbine with the output of mechanical power.

10. Method according to one of Claims 7 to 9, in which the thermodynamic cycle is a Kalina process.

11. Method according to Claim 7, in which the waste heat which is generated by the processors (3) of the computer system (1) drives an absorption refrigeration machine.

12. Method according to one of Claims 7 to 11, in which a large number of evaporators for evaporating the working medium is provided, the said evaporators each being in direct thermal contact with at least one processor (3).

13. Method according to one of Claims 7 to 11, in which a large number of heat absorbers (35) is provided, the said heat absorbers each being in direct thermal contact with at least one processor (3), and a heat exchanger (13, 23, 33) is provided, the said heat exchanger being thermally coupled to the heat absorbers by means of a circulating coolant and being in direct thermal contact with an evaporator for evaporating the working medium, and in which method the waste heat which is given off by the processors (3) is transferred to the evaporator by means of the heat absorbers (35), the coolant and the heat exchanger (13, 23, 33).

14. Method according to one of Claims 1 to 13, in which a virtual machine system is realized on at least some of the processors (3) of the computer system (1).

15. System comprising
- a computer system (1) having a plurality of processors (3),
- a cooling apparatus for dissipating the waste heat from at least some of the processors (3), and
- an apparatus for making use of the waste heat from the processors (3),
**characterized in that** the system is suitable for carrying out a method according to one of Claims 1-14.

## Revendications

1. Procédé d'utilisation de la chaleur dégagée par un système informatique (1) doté de plusieurs processeurs (3), le procédé présentant les étapes suivantes :
répartition des tâches de travail entre les processeurs (3) du système informatique (1) au moyen d'un programmateur (6) de telle sorte que les processeurs (3) d'un premier groupe de processeur (3) soient utilisés à la charge la plus élevée possible et que le processeur (3) d'un deuxième groupe de processeur (3) soient utilisés à la plus petite charge possible et
transfert de la chaleur dégagée par les processeurs (3) du premier et du deuxième groupe dans deux circuits différents (10, 20) de fluide de refroidissement au moyen de soupapes (12, 22) commandées par le programmateur (6), en vue de récupérer la chaleur dégagée.

2. Procédé selon la revendication 1, dans lequel seule la chaleur dégagée par les processeurs (3) du premier groupe est transférée au dispositif de récupération de la chaleur dégagée.

3. Procédé selon la revendication 2, dans lequel un deuxième dispositif de récupération de la chaleur dégagée est prévu, la chaleur dégagée par les processeurs (3) du système informatique (1) qui ne transmettent pas la chaleur qu'ils dégagent au dispositif de récupération de la chaleur dégagée est transmise à l'autre dispositif de récupération de la chaleur dégagée.

4. Procédé selon l'une des revendications 1 à 3, dans lequel les processeurs (3) du deuxième groupe de processeur (3) sont utilisés dans un mode à tension plus basse et/ou à fréquence d'horloge plus basse que dans le mode de fonctionnement normal.

5. Procédé selon l'une des revendications 1 à 4, dans lequel la chaleur dégagée par les processeurs (3) est évacuée par un dispositif de refroidissement et la quantité de chaleur évacuée de chacun des processeurs (3) est régulée par le dispositif de refroidissement de telle sorte que le processeur (3) prenne une température supérieure à une température minimale prédéterminée.

6. Procédé selon l'une des revendications 1 à 5, dans lequel la chaleur dégagée par les processeurs (3) du système informatique (1) est transférée au moins en partie dans un système de chauffage et/ou un système de préparation d'eau chaude.

7. Procédé selon l'une des revendications 1 à 6, dans lequel la chaleur produite par les processeurs (3) du système informatique (1) est apportée au moins en partie à un processus à cycle thermodynamique.

8. Procédé selon la revendication 7, dans lequel la chaleur produite par les processeurs (3) du système informatique (1) entraîne une machine thermique.

9. Procédé selon la revendication 8, dans lequel un fluide de travail est évaporé dans le processus à cycle thermodynamique par la chaleur produite par le processeur (3) du système informatique (1) et dans lequel le fluide de travail est détendu dans une turbine à vapeur en délivrant de l'énergie mécanique.

10. Procédé selon l'une des revendications 7 à 9, dans lequel le processus à cycle thermodynamique est un processus de Kalina.

11. Procédé selon la revendication 7, dans lequel la chaleur produite par les processeurs (3) du système informatique (1) entraîne une machine frigorifique à absorption.

12. Procédé selon l'une des revendications 7 à 11, dans lequel plusieurs évaporateurs servant à évaporer le fluide de travail et qui sont chacun en contact thermique direct avec au moins un processeur (3) sont prévus.

13. Procédé selon l'une des revendications 7 à 11, dans lequel plusieurs accepteurs de chaleur (35) sont prévus et sont chacun en contact thermique direct avec au moins un processeur (3), et un échangeur de chaleur (13, 23, 33) raccordé thermiquement aux accepteurs de chaleur par l'intermédiaire d'un fluide de refroidissement en circulation et en contact direct avec un évaporateur destiné à évaporer le fluide de travail est prévu, et dans lequel la chaleur dégagée par les processeurs (3) est transférée à l'évaporateur par l'intermédiaire de l'accepteur de chaleur (35), du fluide de refroidissement et des échangeurs de chaleur (13, 23, 33).

14. Procédé selon l'une des revendications 1 à 13, dans lequel un système de machine virtuelle est exécuté sur au moins une partie des processeurs (3) du système informatique (1).

15. Système comprenant :
un système informatique (1) doté de plusieurs processeurs (3),
un dispositif de refroidissement qui évacue la chaleur d'au moins une partie des processeurs (3) et
un dispositif d'utilisation de la chaleur dégagée par les processeurs (3),
**caractérisé en ce que**
le système convient pour exécuter un procédé selon l'une des revendications 1 à 14.
